# EUROPEAN PATENT SPECIFICATION

(11) **EP 1 229 655 B1**
(45) Date of publication and mention of the grant of the patent: **14.06.2006**
(21) Application number: 02250528.3
(22) Date of filing: 25.01.2002
(51) Int. Cl.: H03L 7/087, H03L 7/22, H03L 7/113, H03L 7/20

(54) **Phase locked loop apparatus**
Vorrichtung mit einer Phasenregelschleife
Dispositif à boucle d'asservissement de phase

(30) Priority: 30.01.2001 IT TO010083
(43) Date of publication of application: 07.08.2002
(73) Proprietor: Marconi Mobile SpA, 16153 Genoa (IT)
(72) Inventor: Pomona, Ignazio, 95024 Acireale CT (IT); Russo, Mario, 95020 Acireale CT (IT); Leonardi, Orazio, 95024 Acireale CT (IT)
(74) Representative: Tolfree, Roger

(56) References cited:
- EP-A- 0 611 134
- US-A- 3 588 732
- US-A- 4 994 762
- US-A- 5 128 633

## Description

The present invention relates to phased locked loop apparatus and a method of phase locking a reference frequency with a second frequency.

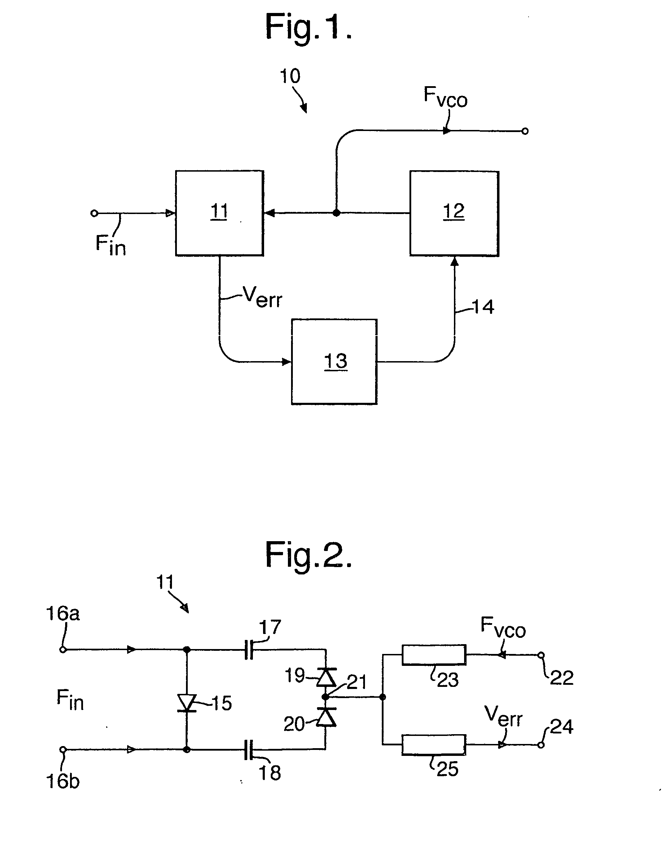

As shown in Figure 1, a conventional analogue phase locked loop apparatus 10 has a sampling phase detector 11 arranged to determine the phase difference between a fixed external input frequency signal Fᵢₙ and an internal input frequency signal F_{vco} generated by a voltage controlled oscillator 12. If the phase of external and internal input frequency signals Fᵢₙ and F_{vco} differ, then the sampling phase detector 11 generates a sine-wave error signal Vₑᵣᵣ which passes through a loop filter 13 and via a feedback pathway 14 to an input of the voltage controlled oscillator 12. The error signal Vₑᵣᵣ causes the internal input frequency signal F_{vco} generated by the voltage controlled oscillator 12 to deviate towards the fixed external input frequency signal Fᵢₙ so as to reduce the value of the error signal Vₑᵣᵣ. This cyclic process continues until the internal input frequency signal F_{vco} maintains a fixed phase relationship with the fixed external input frequency signal Fᵢₙ. When the phase relationship between the internal and external input frequency signals F_{vco} and Fᵢₙ becomes fixed, then the error signal Vₑᵣᵣ will become a direct current signal. It will be understood that the loop filter 13 is constructed to inhibit instabilities in the feedback pathway 14.

Referring to Figure 2, a sampling phase detector 11 of the phase locked loop apparatus 10 shown in Figure 1, comprises a step recovery diode 15 arranged across input terminals 16a and 16b which are arranged to receive the fixed external input frequency signal Fᵢₙ. The sampling phase detector 11 also comprises two networks each having a capacitor 17 and 18 coupled via one of its terminals to one terminal of a respective Schottky type diode 19 or 20. Each of the capacitors 17 and 18 are also connected via its other terminal to one terminal of the step recovery diode 15. The other terminal of each Schottky type diode 19 and 20 are connected to one another via terminal 21.

The internal input frequency signal F_{vco} is supplied by terminal 22 and to terminal 21 via a first filter 23. The error signal Vₑᵣᵣ is provided at terminal 24 and corresponds to the phase difference between the internal and external input frequency signals F_{vco} and Fᵢₙ and is taken from terminal 21 and passes through a second filter 25. It will be understood that the sampling phase detector 11 is analogue in nature and that the sampling rate is dependent on the frequency of the external input frequency signal Fᵢₙ.

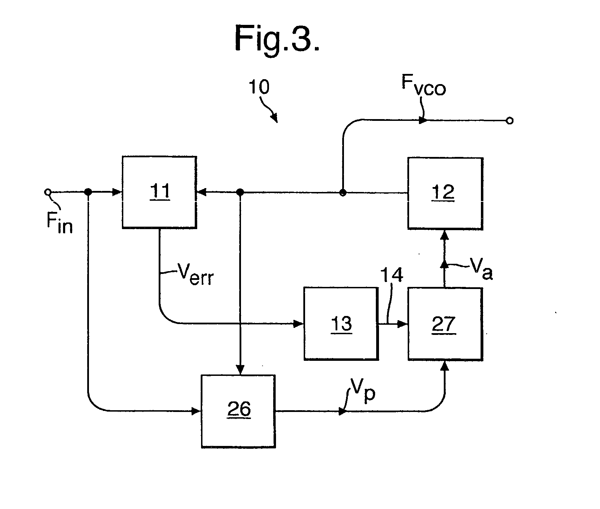

However, should an unlocked condition occur, that is the internal input frequency signal F_{vco} does not maintain a fixed relationship with the fixed external input frequency signal Fᵢₙ, then the phase locked loop apparatus 10 should include a frequency discriminator system to provide an automatic search function to mitigate this problem. Such a frequency discriminator system is illustrated in Figure 3, in which like references have been used to indicate similar integers to those shown in Figure 1. A frequency discriminator 26 is arranged to receive and compare the internal and external input frequency signals F_{vco} and Fᵢₙ and provide an output voltage product Vₚ proportioned to the amount the internal input frequency F_{vco} differs with respect to the fixed external input frequency Fᵢₙ. The output voltage product Vₚ is supplied to a summation function 27 which is included in the feedback pathway 14 and is arranged to also receive the error signal Vₑᵣᵣ after it has passed through the loop filter 13. The summation function 27 provides an aggregate voltage Vₐ from the error signal Vₑᵣᵣ and output voltage product Vₚ which is then supplied to the voltage controlled oscillator 12 to deviate the internal input frequency signal F_{vco} as described above with respect to Figure 1.

However, although an analogue phase locked loop apparatus 10 of Figures 1 to 3 provides low phase noise performance, a problem arises if the internal input frequency signal F_{vco} has a large tuneable frequency range compared with the fixed frequency value of the external input frequency signal Fᵢₙ. For example, the internal input frequency signal F_{vco} may have a large tuneable frequency range, typically from 2180 to 2680 MHz, that is a 500 MHz bandwidth, so that the voltage controlled oscillator 12 can be used to tune to many frequency values within its 500 MHz bandwidth, and the external input frequency signal Fᵢₙ may have a comparably small fixed frequency value, typically 10 MHz. In this example, the phase locked loop apparatus 10 of the prior art will not be able to properly lock the 10 MHz fixed external input frequency signal Fin because of the tuning range of 500 MHz bandwidth provided by the voltage controlled oscillator 12 is substantially larger than the fixed Fᵢₙ value. For example, if the internal input frequency signal F_{vco} is sampled by the external input frequency signal Fᵢₙ at a rate of 10 MHz then it is possible that a locked condition between the internal and external input frequency signals F_{vco} and Fᵢₙ could occur every 10MHz in the tuneable frequency range 2180 to 2680 MHz of the voltage controlled oscillator 12, that is, 51 times over the tuneable frequency range.

Patent US 4, 994, 762 shows a multiple loop synthesizer with two PLLS capable of operating in a wide range of frequencies.

It is an object of the present invention to obviate or mitigate the disadvantages associated with the prior art.

According to a first aspect of the present invention a phase locked loop apparatus comprises a first phase locked loop having a sampling phase detector arranged to determine an error signal corresponding to the phase difference between a reference frequency and a frequency generated by a variable frequency oscillator, the error signal being used to control the frequency generated by the variable frequency oscillator so as to reduce the error signal, and is *characterised by* means for determining the direction the frequency of the oscillator needs to move in order to match the reference frequency and a processor associated with the second phase locked loop arranged to vary the error signal in accordance with the direction, determined as aforesaid, until the value of the error signal is within a predefined value range.

In this manner, a variable frequency oscillator arranged to be capable of generating a relatively broad bandwidth of frequencies can be locked with a given or applied fixed reference frequency. It will be understood that use of such a variable frequency oscillator with broad bandwidth allows the apparatus to lock with more than one frequency over a broader range.

Preferably, the direction indicator may be arranged to alter when the phase difference between the reference frequency and the frequency generated by the variable frequency oscillator changes sign.

The processor may be initially arranged to vary the error signal in a predetermined step size until signalled by the second phase locked loop and then arranged to vary the error signal in a smaller predetermined step size. In this manner, the time taken to resolve the value of the error signal to within a predefined value range, that is to lock the frequency generated by the variable frequency oscillator with the reference frequency, can be reduced. The second phase locked loop may be arranged to signal the processor to switch from one predetermined step size to another, smaller predetermined step size in accordance with the direction indicator. The processor may be arranged to select between two or more step sizes in accordance with the direction indicator.

Preferably, the processor may be arranged to continue varying the error signal until the processor determines that the error signal is within a predetermined value range with respect to the dynamic range of the sampling phase detector. Alternatively, the processor may be arranged to continue varying the error signal until the processor determines that the error signal is substantially in the middle of a predetermined value range with respect to the dynamic range of the sampling phase detector.

A user frequency setting may be stored by the processor and the processor may be arranged to determine the divisional factors for the user frequency setting and the reference frequency. The processor may be arranged to determine a step size to be applied to the first phase locked loop to achieve a phase lock between the reference frequency and the frequency generated by the variable frequency oscillator.

Preferably, the first phase locked loop may be analogue and the second phase locked loop may be digital. In this manner, the low phase noise characteristics of an analogue phase locked loop can be combined with the large tuning range programmable nature of a digital phase locked loop.

According to another aspect of the invention a method of phase locking a reference frequency with a second frequency including the steps of
a) determining as an error signal, the phase difference between the reference frequency (43) and the second frequency (50), and
b) using the error signal to control the second frequency (50) so as to reduce the error signal,
   is characterized by the further steps of
c) determining the direction the second frequency (50) needs to move in order to match the reference frequency (43), and
d) varying the error signal in a manner which is dependant on the result of step c) until the value of the error signal is within a predefined value range.

According to another aspect of the invention a communications system, comprises at least one remote unit and at least one base station arranged to communicate with each remote unit over a communication channel, wherein the remote unit and/or the base station is comprise a phased locked loop apparatus in accordance with the invention.

According to another aspect of the invention a method of operating a communications system having at least one remote unit and at least one base station arranged to communicate with each remote unit over a communication channel, the remote unit and/or the base station having a phased locked loop apparatus operating in accordance with the invention.

The invention will now be described, by way of example only, with reference to the accompanying drawings, in which:
**Figure 1** illustrates a block diagram of a phase locked loop apparatus according to the prior art;
**Figure 2** illustrates a detailed block diagram of the sampling phase detector shown in Figure 1;
**Figure 3** illustrates a modified phase lock loop apparatus similar to that shown in Figure 1 and according to the prior art;
**Figure 4** illustrates a schematic diagram of a phase locked loop apparatus according to the invention, and
**Figure 5** illustrates a flow diagram of the operation of the phase locked loop shown in Figure 4.

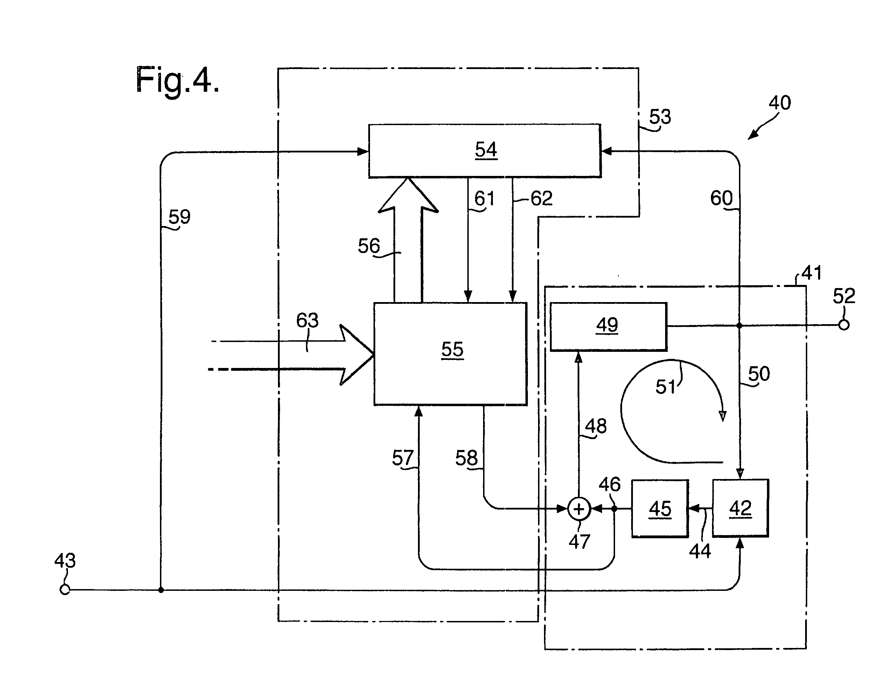

Referring to Figure 4, a phase locked loop apparatus 40 comprises an analogue phase locked loop 41 having a sampling phase detector 42 arranged to receive an external input frequency signal 43 on a first input which is sampled to produce a sampled output 44 which is fed to the input of a loop filter 45. The loop filter 45 generates an output 46 which passes to a summation function 47 which produces a resultant output 48 that then passes to a control input of a variable frequency oscillator such as a voltage controlled oscillator 49. The voltage controlled oscillator 49 is arranged to produce an internal input frequency signal 50 in accordance with the resultant output 48 applied to its control input. The internal input frequency signal 50 then passes back to a second input of the sampling phase detector 42. It will be understood that the sampling phase detector42, loop filter 45, summation function 47 and voltage controlled oscillator 49 operate in a feedback pathway 51.

In operation, the phase detector 42 determines the phase difference between the external input frequency signal 43 and the internal input frequency signal 50 generated by the voltage controlled oscillator 49. If the phase of the external and internal input frequency signals 43 and 50 differ, then the phase detector 42 generates an error signal, in this case represented by sampled output 44. The sampled output 44 passes through the loop filter 45 and via the summation function 47 through feedback pathway 51 to the control input of the voltage controlled oscillator 49 as the resultant output 48. The resultant output 48 causes the voltage controlled oscillator 49 to deviate the internal input frequency signal 50 in the direction of the external input frequency signal 43 so as to reduce the value of the sampled output 44 from the phase detector 42. This cyclic process continues until the internal input frequency signal 50 maintains a fixed phase relationship with the external input frequency signal 43 at which point the sampled output 44 will become a direct current signal.

When the phase relationship between the internal and external input frequency signals 50 and 43 becomes fixed, then the internal input frequency signal 50 locks with the external input frequency signal 43. The internal input frequency signal 50 can be tapped off the feedback pathway 51 at any convenient point, for example terminal 52 between the output of the voltage controlled oscillator 49 and the second input to the phase detector 42.

It will be understood that the loop filter 45 is constructed to inhibit instabilities in the feedback pathway 51.

A second phase locked loop 53 comprises a digital phase locked loop unit 54 and a microprocessor unit 55 which are connected to and control the operation of the analogue phase locked loop 41. The microprocessor unit 55 is arranged to determine the step size and frequency range for which the digital phase locked loop unit 54 should operate. These parameters are conveyed to the digital phase locked loop unit 54 over control line 56.

The microprocessor unit 55 is arranged to receive the output 46 from the loop filter 45 via input line 57 in order to determine the current condition of the analogue phase locked loop 41. Responsive to the current condition of the analogue phase locked loop 41, the microprocessor unit 55 is also arranged to vary the input to the voltage controlled oscillator 49 by applying a suitable signal over output line 58 which is then summed with the output 46 of the loop filter 45 by the summation function 47. It will be understood that variation of the signal on output line 58 will vary the resultant output 48 which is fed to the input of the voltage controlled oscillator 49 so as to tune the internal input frequency signal 50 generated by the voltage controlled oscillator 49 to the external input frequency signal 43.

The digital phase locked loop unit 54 is arranged to receive the external input frequency 43 over input line 59 and the internal input frequency signal 50 generated by the voltage controlled oscillator 49 over input line 60.

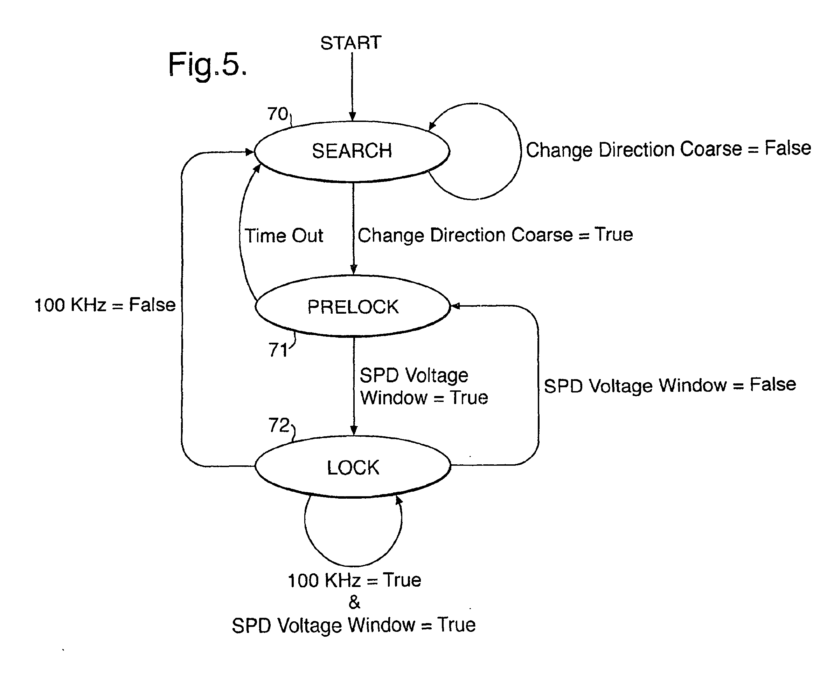

The digital phase locked loop unit 54 operates in a manner indicated in Figure 5 which will be described in greater detail below. However, in general terms the digital phase locked loop unit 54 generates a direction indicator on an output 61 which is fed to a second input of the microprocessor unit 55 so as to control the operation of the analogue phase locked loop 41. The direction indicator is generated by the digital phase locked loop 54 when it makes a comparison of the external input frequency signal 43 with the internal input frequency signal 50 and determines the direction the internal input frequency signal 50 needs to move in order to match the external input frequency signal 43. The direction indicator is the result of this comparison and the microprocessor unit 55 uses the direction indicator to calculate the value which needs to be applied over output line 58 to the summation function 47 of the analogue phase locked loop 41 so that the analogue phase locked loop 41 can more quickly tune the internal input frequency signal 50 to the external input frequency signal 43.

The microprocessor unit 55 determines when the output 46 from the loop filter 45 is within a predetermined window or value range by receiving the output 46 via input line 57 and comparing the output 46 with a predefined value range. The digital phase locked loop unit 54 also provides an indication that it has a predefined expected value range via line 62. It should be noted that the predetermined window or value range is in fact part or all of the dynamic range of the sampling phase detector 42.

It will be understood that the speed of the digital phase locked loop unit 54 can be used to quickly determine which direction the frequency search conducted by the analogue phase locked loop 41 needs to move so that the internal input frequency signal 50 can be located nearer the external input frequency signal 43. In this way, the analogue phase locked loop 41 can be used to phase lock the internal input frequency signal 50 to the external input frequency signal 43 in a more efficient manner.

Referring to Figure 5, the phase locked loop apparatus 40 described with reference to Figure 4 operates as follows:

### 1. Search Mode

The process starts in a search mode 70 when 55 the microprocessor unit 55 applies a relatively large signal to the summation function 47 so as to ensure relatively large changes in the internal input frequency signal 50 generated by the voltage controlled oscillator 49. Then the digital phase locked loop unit 54 compares the internal and external input frequency signals 50 and 43 in order to determine when the values of the internal and external input frequency signals 50 and 43 cross. The digital phase locked loop unit 54 compares the internal and external input frequency signals 50 and 43 in accordance with the parameters defined by the microprocessor unit 55 and conveyed over control line 56 and which will be explained below. The search process continues in the search mode 70 until the digital phase locked loop unit 54 indicates to the microprocessor unit 55, via the direction indicator over output 61, that the direction of the search process has changed. At this point the microprocessor unit 55 moves from the search mode 70 into a prelocked mode 71.

### 2. Prelocked Mode

In the prelocked mode 71 the microprocessor unit 55 tries to determine if the output 46 from the loop filter 45 is within a predefined window corresponding to the dynamic range of the sampling phase detector 42. This process continues in the prelocked mode 71 until either the output 46 is determined to fall within the predefined window or a predefined time out period has expired. In the event of the time out period expiring the microprocessor unit 55 will revert back to the search mode 70. If the output 46 is within the predefined window the microprocessor unit 55 will then attempt to locate the output 46 in the center of the predefined window by applying a relatively smaller signal via output line 58 to the summation function 27 to ensure only small changes in the internal input frequency signal 50 and will continue to monitor the output signal 46 and compare it with a predetermined value range.

When the microprocessor unit 55 has determined that the output 46 is substantially in the center of the predefined window the process then moves into a locked mode 72.

### 3. Locked Mode

The process will remain in the locked mode 72 while the following parameters remain true for the phase locked loop apparatus 40:
1. the output 46 is within the predefined window, and
2. the digital phase locked loop unit 54 indicates via line 62 that it has a predefined expected value.

Should either of these two conditions not be met the microprocessor unit 55 will revert to the search mode 70. It will be understood that while the microprocessor unit 55 is in the locked mode 72 the analogue phase locked loop 41 will search for and track the external input frequency signal 43 in a conventional manner as the microprocessor unit 55 will not need to apply any signal via output line 58 to the summation function 47.

Referring back to Figure 4, a user may input a frequency setting value, for example 2510 MHz, via a user input 63 connected to the microprocessor unit 55. The microprocessor unit 55 will then calculate the necessary division factors for the inserted frequency setting value and external input frequency signal 43, and convey these factors to the digital phase locked loop unit 54.

In this example, the required frequency or the internal input frequency signal 50 of 2510 MHz is divided to by an adopted comparison frequency of for example 100 KHz (2510 MHz/100 KHz = 25100) and external input frequency signal 43 of 10 MHz is divided by the adopted comparison frequency of 100 KHz (10 MHz/100 KHz = 100). The digital phase locked loop unit 54 will then corn's pare the internal and external input frequency signals 50 and 43 at the adopted comparison frequency (100 KHz), by means of its internal phase detector which generates the direction indicator over the output 61 and the 100 KHz signal over line 62 to be addressed to the microprocessor unit 55.

## Claims

1. A phase locked loop apparatus, comprising a first phase locked loop (41) having a sampling phase detector (42)arranged to determine an error signal (48) corresponding to the phase difference between a reference frequency (43) and a frequency (50) generated by a variable frequency oscillator (49), the error signal (48) being used to control the frequency generated by the variable frequency oscillator (49)so as to reduce,the error signal (48), ***characterised by*** means (54) for determining the direction the frequency of the oscillator (50) needs to move in in order to match the reference frequency (43) and a processor (55) associated with a second phase locked loop (53) arranged to vary the error signal (48) in accordance with the direction, determined as aforesaid, until the value of the error signal (48) is within a predefined value range.

2. A phase locked loop apparatus, as in Claim 1, **characterized in that** the means (43) for determining the direction is designed to detect the sign of the phase difference between the reference frequency (43) and the frequency (50) generated by the variable frequency oscillator (49) and to produce an output (58) dependant on such detection.

3. A phase locked loop apparatus, as in Claims 1 or 2, **characterized in that** the processor is initially arranged to vary the error signal (48) in a predetermined step size until a change in the said direction is detected and then to vary the error signal (48) in a smaller predetermined step size.

4. A phased locked loop apparatus, as in Claim 3, **characterized in that** the second phase locked loop (53) is arranged to signal the processor (55) to switch from one predetermined step size to another, smaller step size in accordance with the determined direction.

5. A phase locked loop apparatus, as in Claims 3 or 4, **characterized in that** the processor (55) is arranged to select between two or more step sizes in accordance with the determined direction.

6. A phase locked loop apparatus, as in any preceding claim, **characterized in that** the processor (55) is arranged to continue varying the error signal (48) until the processor (55) determines that the error signal (48) is within a predetermined value range with respect to dynamic range of the sampling phase detector (42).

7. A phase locked loop apparatus, as in Claims 1 to 6, **characterized in that** the processor (55) is arranged to continue varying the error signal (48) until the processor (55) determines that the error signal (48) is substantially in the middle of a predetermined value range with respect to the dynamic range of the sampling phase detector (42).

8. A phased locked loop apparatus, as in any preceding claim, **characterized in that** a user frequency setting (63) is stored by the processor and the processor is arranged to determine divisional factors for the user frequency setting and the reference frequency (43).

9. A phase locked loop, as in Claim 8, **characterized in that** the processor (55) is arranged to determine a step size to be applied to the first phase locked loop (41) to achieve a phase lock between the reference frequency (43) and the frequency (50) generated by the variable frequency oscillator (49).

10. A phase locked loop apparatus, as in any preceding claim **characterized in that** wherein the first phase locked loop (41) is analogue and the second phase locked loop (53) is digital.

11. A method of phase locking a reference frequency (43) with a second frequency (50) including
a) determining as an error signal, the phase difference between the reference frequency (43) and the second frequency (50), and
b) using the error signal to control the second frequency (50) so as to reduce the error signal,
**characterized by** the further steps of
c) determining the direction the second frequency (50) needs to move in order to match the reference frequency (43), and
d) varying the error signal in a manner which is dependant on the result of step c) until the value of the error signal is within a predefined value range.

12. A communications system, comprising at least one remote unit and at least one base station arranged to communicate with each remote unit over a communication channel, wherein the remote unit and/or the base station comprises a phased locked loop apparatus according Claims 1 to 10.

13. A method of operating a communications system having at least one remote unit and at least one base station arranged to communicate with each remote unit over a communication channel, the remote unit and/or the base station having a phased locked loop apparatus operating according to Claim 11.

## Patentansprüche

1. Phasenregelkreisvorrichtung, die einen ersten Phasenregelkreis (41) umfasst, der einen Abtastphasendetektor (42) aufweist, der dafür konfiguriert ist, ein Fehlersignal (48) zu ermitteln, das der Phasendifferenz zwischen einer Bezugsfrequenz (43) und einer Frequenz (50) entspricht, die von einem durchstimmbaren Oszillator (49) erzeugt wurde, wobei das Fehlersignal (48) zum Steuern der von dem durchstimmbaren Oszillator (49) erzeugten Frequenz verwendet wird, um das Fehlersignal (48) zu verringern, **gekennzeichnet durch** ein Mittel (54) zum Feststellen der Richtung, in die sich die Frequenz des Oszillators (50) bewegen muss, um mit der Bezugsfrequenz (43) übereinzustimmen, und einen Prozessor (55), der einem zweiten Phasenregelkreis (53) zugeordnet ist, welcher dafür konfiguriert ist, das Fehlersignal (48) entsprechend jener festgestellten Richtung zu verändern, bis der Wert des Fehlersignals (48) innerhalb eines vorgegebenen Wertebereichs liegt.

2. Phasenregelkreisvorrichtung nach Anspruch 1, **dadurch gekennzeichnet, dass** das Mittel (54) zum Feststellen der Richtung dafür konfiguriert ist, das Vorzeichen der Phasendifferenz zwischen der Bezugsfrequenz (43) und der Frequenz (50), die von dem durchstimmbaren Oszillator (49) erzeugt wurde, zu erkennen und ein von dieser Richtung abhängiges Ausgangssignal (58) zu erzeugen.

3. Phasenregelkreisvorrichtung nach Anspruch 1 oder 2, **dadurch gekennzeichnet, dass** der Prozessor anfänglich dafür konfiguriert ist, das Fehlersignal (48) in einer vorgegebenen Schrittgröße zu verändern, bis eine Änderung jener Richtung erkannt wird, und dann das Fehlersignal (48) in einer kleineren vorgegebenen Schrittgröße zu verändern.

4. Phasenregelkreisvorrichtung nach Anspruch 3, **dadurch gekennzeichnet, dass** der zweite Phasenregelkreis (53) dafür konfiguriert ist, dem Prozessor (55) zu signalisieren, entsprechend der festgestellten Richtung von einer vorgegebenen Schrittgröße zu einer anderen, kleineren Schrittgröße zu wechseln.

5. Phasenregelkreisvorrichtung nach Anspruch 3 oder 4, **dadurch gekennzeichnet, dass** der Prozessor (55) dafür konfiguriert ist, entsprechend der festgestellten Richtung zwischen zwei oder mehr Schrittgrößen zu wählen.

6. Phasenregelkreisvorrichtung nach einem der vorangehenden Ansprüche, **dadurch gekennzeichnet, dass** der Prozessor (55) dafür konfiguriert ist, das Fehlersignal (48) fortgesetzt zu verändern, bis der Prozessor (55) feststellt, dass das Fehlersignal (48) hinsichtlich des Dynamikbereichs des Abtastphasendetektors (42) innerhalb eines vorgegebenen Wertebereichs liegt.

7. Phasenregelkreisvorrichtung nach den Ansprüchen 1 bis 6, **dadurch gekennzeichnet, dass** der Prozessor (55) dafür konfiguriert ist, das Fehlersignal (48) fortgesetzt zu verändern, bis der Prozessor (55) feststellt, dass das Fehlersignal (48) hinsichtlich des Dynamikbereichs des Abtastphasendetektors (42) im Wesentlichen in der Mitte eines vorgegebenen Wertebereichs liegt.

8. Phasenregelkreisvorrichtung nach einem der vorangehenden Ansprüche, **dadurch gekennzeichnet, dass** eine Benutzerfrequenzeinstellung (63) durch den Prozessor gespeichert wird und der Prozessor dafür konfiguriert ist, Teilungsfaktoren für die Benutzerfrequenzeinstellung und die Bezugsfrequenz (43) zu bestimmen.

9. Phasenregelkreisvorrichtung nach Anspruch 8, **dadurch gekennzeichnet, dass** der Prozessor (55) dafür konfiguriert ist, eine auf den ersten Phasenregelkreis (41) anzuwendende Schrittgröße zu bestimmen, um eine Phasenverriegelung zwischen der Bezugsfrequenz (43) und der von dem durchstimmbaren Oszillator (49) erzeugten Frequenz herzustellen.

10. Phasenregelkreisvorrichtung nach einem der vorangehenden Ansprüche, **dadurch gekennzeichnet, dass** der erste Phasenregelkreis (41) analog ist und der zweite Phasenregelkreis digital ist.

11. Verfahren zur Phasenverriegelung einer Bezugsfrequenz (43) mit einer zweiten Frequenz (50), enthaltend:
a) Feststellen der Phasendifferenz zwischen der Bezugsfrequenz (43) und der zweiten Frequenz (50) als ein Fehlersignal, und
b) Verwenden des Fehlersignals, um die zweite Frequenz (50) so zu steuern, dass das Fehlersignal verringert wird,
**gekennzeichnet durch** folgende weitere Schritte:
c) Feststellen der Richtung, in die sich die zweite Frequenz (50) bewegen muss, um mit der Bezugsfrequenz (43) übereinzustimmen, und
d) Verändern des Fehlersignals (48) in einer Weise, die von dem Ergebnis des Schrittes c) abhängt, bis der Wert des Fehlersignals innerhalb eines vorgegebenen Wertebereichs liegt.

12. Kommunikationssystem, das wenigstens eine räumlich abgesetzte Einheit und wenigstens eine Basisstation umfasst, die dafür konfiguriert ist, mit jeder räumlich abgesetzten Einheit über einen Kommunikationskanal zu kommunizieren, wobei die räumlich abgesetzte Einheit und/oder die Basisstation eine Phasenregelkreisvorrichtung nach den Ansprüchen 1 bis 10 umfassen.

13. Verfahren zum Betreiben eines Kommunikationssystems, das wenigstens eine räumlich abgesetzte Einheit und wenigstens eine Basisstation aufweist, die dafür konfiguriert ist, mit jeder räumlich abgesetzten Einheit über einen Kommunikationskanal zu kommunizieren, wobei die räumlich abgesetzte Einheit und/oder die Basisstation eine Phasenregelkreisvorrichtung nach Anspruch 11 aufweist.

## Revendications

1. Dispositif de boucle à verrouillage de phase, comprenant une première boucle à verrouillage de phase (41) comportant un détecteur d'échantillonnage (42) conçu pour déterminer un signal d'erreur (48) correspondant à la différence de phase entre une fréquence de référence (43) et une fréquence (50) générée par un oscillateur à fréquence variable (49), le signal d'erreur (48) étant utilisé pour contrôler la fréquence générée par l'oscillateur à fréquence variable (49) afin de réduire le signal d'erreur (48), **caractérisé par** un moyen (54) de détermination de la direction suivant laquelle la fréquence de l'oscillateur (50) doit se déplacer afin de se conformer à la fréquence de référence (43) et un processeur (55) associé à une seconde boucle à verrouillage de phase (53) et disposé de manière à faire varier le signal d'erreur (48) en fonction de la direction, déterminée comme indiqué précédemment, jusqu'à ce que la valeur du signal d'erreur (48) se situe dans une plage de valeur prédéfinie.

2. Dispositif de boucle à verrouillage de phase selon la revendication 1, **caractérisé en ce que** le moyen (43) de détermination de la direction est conçu pour détecter le signe de la différence de phase entre la fréquence de référence (43) et la fréquence (50) générée par l'oscillateur à fréquence variable (49) et pour émettre une valeur de sortie (58) dépendant de cette détection.

3. Dispositif de boucle à verrouillage de phase selon les revendications 1 ou 2, **caractérisé en ce que** le processeur est initialement conçu pour faire varier le signal d'erreur (48) dans une amplitude d'étape prédéterminée jusqu'à ce qu'un changement de ladite direction soit détecté puis pour faire varier le signal d'erreur (48) dans une amplitude d'étape plus petite prédéterminée.

4. Dispositif de boucle à verrouillage de phase selon la revendication 3, **caractérisé en ce que** la seconde boucle à verrouillage de phase (53) est conçue pour signaler au processeur (5) qu'il doit passer d'une amplitude d'étape prédéterminée à une autre amplitude d'étape plus petite en fonction de la direction déterminée.

5. Dispositif de boucle à verrouillage de phase selon les revendications 3 ou 4, **caractérisé en ce que** le processeur (55) est conçu pour choisir entre deux amplitudes d'étape ou davantage en fonction de la direction déterminée.

6. Dispositif de boucle à verrouillage de phase selon l'une quelconque des revendications précédentes, **caractérisé en ce que** le processeur (55) est conçu pour continuer à faire varier le signal d'erreur (48) jusqu'à ce que le processeur (55) détermine que le signal d'erreur (48) se situe dans une plage de valeur prédéterminée par rapport à la plage dynamique du détecteur de phase d'échantillonnage (42).

7. Dispositif de boucle à verrouillage de phase selon les revendications 1 à 6, **caractérisé en ce que** le processeur (55) est conçu pour continuer à faire varier le signal d'erreur (48) jusqu'à ce que le processeur (55) détermine que le signal d'erreur (48) se situe sensiblement au milieu d'une plage de valeur prédéterminée par rapport à la plage dynamique du détecteur de phase d'échantillonnage (42).

8. Dispositif de boucle à verrouillage de phase selon l'une quelconque des revendications précédentes, **caractérisé en ce qu'**un réglage de fréquence utilisateur (63) est sauvegardé par le processeur et que le processeur est conçu pour déterminer des facteurs de division pour le réglage de fréquence utilisateur et la fréquence de référence (43).

9. Dispositif de boucle à verrouillage de phase selon la revendication 8, **caractérisé en ce que** le processeur (55) est conçu pour déterminer une amplitude d'étape à appliquer à la première boucle à verrouillage de phase (41) afin de réaliser un verrouillage de phase entre la fréquence de référence (43) et la fréquence (50) générée par l'oscillateur à fréquence variable (49).

10. Dispositif de boucle à verrouillage de phase selon l'une quelconque des revendications précédentes, **caractérisé en ce que** la première boucle à verrouillage de phase (41) est analogique et que la deuxième boucle à verrouillage de phase (53) est numérique.

11. Procédé de verrouillage de phase d'une fréquence de référence (43) avec une seconde fréquence (50), comprenant
a) la détermination en tant que signal d'erreur de la différence de phase entre la fréquence de référence (43) et la seconde fréquence (50), et
b) l'utilisation du signal d'erreur pour contrôler la seconde fréquence (50) de manière à réduire le signal d'erreur,
**caractérisé par** les autres étapes de
c) détermination de la direction suivant laquelle la seconde fréquence (50) doit se déplacer pour se conformer à la fréquence de référence (43), et
d) variation du signal d'erreur d'une manière dépendant du résultat de l'étape c) jusqu'à ce que la valeur du signal d'erreur se situe dans une plage de valeur prédéfinie.

12. Système de communication, comprenant au moins une unité distante et au moins un poste de base conçu pour communiquer avec chaque unité distante par un canal de communication, dans lequel l'unité distante et/ou le poste de base comprend un dispositif de boucle à verrouillage de phase selon les revendications 1 à 10.

13. Procédé d'utilisation d'un système de communication comportant au moins une unité distante et au moins un poste de base conçu pour communiquer avec chaque unité distante par un canal de communication, l'unité distante et/ou le poste de base comprenant un dispositif de boucle à verrouillage de phase fonctionnant suivant la revendication 11.
